(19) Europäisches Patentamt
European Patent Office
Office européen des brevets

(11) **EP 1 641 037 B1**

(12) **EUROPÄISCHE PATENTSCHRIFT**

(45) Veröffentlichungstag und Bekanntmachung des Hinweises auf die Patenterteilung:
**10.06.2009 Patentblatt 2009/24**

(51) Int Cl.:
***H01L 21/683*** *(2006.01)* ***B65G 47/91*** *(2006.01)*

(21) Anmeldenummer: **05020362.9**

(22) Anmeldetag: **19.09.2005**

(54) **Verfahren und Vorrichtung zum Halten und Transportieren eines Werkstücks mit einer ebenen Oberfläche**

Method and device to hold and transport workpieces having flat surfaces

Méthode et dispositif pour tenir et transporter des pièces comportant des surfaces planes

(84) Benannte Vertragsstaaten:
**CH DE FR GB LI NL SE**

(30) Priorität: **22.09.2004 DE 102004045957**

(43) Veröffentlichungstag der Anmeldung:
**29.03.2006 Patentblatt 2006/13**

(73) Patentinhaber: **Singulus Technologies AG**
**63796 Kahl am Main (DE)**

(72) Erfinder:
• **Kempf, Stefan**
**63796 Kahl am Main (DE)**

• **Rohrmann, Reiner**
**63796 Kahl am Main (DE)**

(74) Vertreter: **Vossius & Partner**
**Siebertstrasse 4**
**81675 München (DE)**

(56) Entgegenhaltungen:
**WO-A-99/05915          DE-A1- 3 536 432**
**DE-A1- 3 642 937**

**Beschreibung**

Die Erfindung betrifft eine Vorrichtung für ein Werkstück mit einer ebenen Oberfläche, wobei das Werkstück durch eine durch einen Gasstrom erzeugte Druckdifferenz zwischen Ober- und Unterseite des Werkstücks gehalten wird. Die Erfindung betrifft ferner ein Verfahren zum Anheben eines Werkstücks unter Verwendung der erfindungsgemäßen Vorrichtung.

Im Stand der Technik sind zum gleichzeitigen Ansaugen und Heben von dünnen, porösen und flächigen Werkstücken Vakuum-Hubzylinder bekannt. Ein solcher Hubzylinder ist an einen Vakuum-Erzeuger angeschlossen und mit Vakuum beaufschlagt. Wenn durch den Kontakt des Saugers zum Werkstück ein Unterdruck entsteht, wird das Werkstück angesaugt und so gehalten. Der Saugeffekt wird dabei nur auf das oberste Werkstück und nicht auf die darunter liegenden Werkstücke ausgeübt. Das Werkstück wird gehalten, bis das Vakuum abgeschaltet wird. Um mit einem solchen Hubzylinder ein Werkstück heben zu können, muss der Zylinder über das flächige Werkstück verfahren werden und anschließend auf das Werkstück abgesenkt werden, bis der Sauger in Kontakt zum Werkstück kommt. Es ist also zum Transportieren eines Werkstücks eine Bewegung sowohl parallel zur Oberfläche des Werkstücks als auch senkrecht zu dieser nötig. Weiterhin besteht besonders beim Transport dünner und empfindlicher Werkstücke die Gefahr der Beschädigung des Werkstücks durch den ausgeübten Unterdruck und den physischen Kontakt zwischen Sauger und Werkstück. Auch ist die Anwendung für Werkstücke mit rauen Oberflächen oder für verschmutzte Objekte problematisch, da in diesen Fällen die Gefahr besteht, daß der Sauger nicht luftdicht mit der Oberfläche abschließen kann und dadurch die Haltekraft erheblich verringert oder sogar völlig verhindert wird.

Aus der DE 35 36 432 A1 ist eine Haltevorrichtung bekannt, bei der Halbleiterscheiben berührungslos gehalten und transportiert werden können. Diese Haltevorrichtung weist zum Einleiten von Schutzgas ein Anblasrohr auf, das auf einen Diffusor koaxial aufgesetzt ist; der Diffusor weist dem Ende des Anblasrohrs gegenüberliegend einen koaxialen Verteilerkonus auf. Der dabei ausgenutzte physikalische Effekt des hydrodynamischen Paradoxon kann durch die Bernoullische Gleichung beschrieben werden.

Die Druckdifferenz zwischen dem äußeren Umgebungsdruck und dem sich einstellenden statischen Druck führt dazu, daß das Werkstück abgehoben und transportiert oder gehalten werden kann. Es stellt sich also ein Kräftegleichgewicht zwischen dem Gewicht der Halbleiterscheibe einerseits und der Druckdifferenz andererseits ein.

Um ein radiales Abgleiten und Verkanten des Werkstücks zu verhindern, weist der Diffusor an seinem Umfang vier Führungsstifte sowie Noppen auf.

Die beschriebene Haltevorrichtung ist zwar geeignet, flächige Werkstücke zu halten und zu transportieren, jedoch sind mit dieser Haltevorrichtung beim Transportieren des Werkstücks keine hohen Beschleunigungen senkrecht zur Wirkrichtung der Haltekraft, also in einer Richtung parallel zur Werkstückoberfläche, möglich, da das Werkstück durch die Haltevorrichtung nur durch den Unterdruck zwischen der Haltevorrichtung und dem Werkstück berührungslos, d.h. ohne jeden Oberflächenkontakt gehalten wird. Die Führungsstifte selbst können nur dann ein laterales Abgleiten des Werkstücks senkrecht zur Haltekraft, also in Richtung der Oberfläche des Werkstücks verhindern, wenn der Abstand Werkstück und Vorrichtung während des Haltens und des Transports exakt eingestellt und beibehalten wird, damit die Führungsstifte mit dem Werkstück bündig abschließen. Ist der Abstand zwischen dem Werkstück und dem Diffusor zu groß gewählt, oder wird das Werkstück durch Stöße von der Vorrichtung etwas weggedrückt oder verkippt, so können die Führungsstifte einem lateralen Abgleiten der Werkstücke nicht entgegenwirken. Somit wird, bei einer Beschleunigung senkrecht zur Hubkraft, das Werkstück aufgrund ihrer Trägheit zurückbleiben, wodurch der Unterdruck zwischen Diffusor und Werkstück verloren geht und das Werkstück nicht mehr gehalten werden kann.

Eine ähnliche Vorrichtung ist aus der DE 25 39 036 A1 bekannt. Auch in der DE 36 42 937 A1 ist eine Einrichtung zum berührungslosen Fördern und Aufhängen von Werkstücken beschrieben.

Völlig ungeeignet ist die bekannte Haltevorrichtung zum Halten und Transportieren eines Werkstücks mit einer durchgehenden zentralen Öffnung, etwa im Falle eines optischen Datenträgers, wie z.B. einer CD, DVD oder einer Blu-ray-Disk, da in dem Spalt zwischen dem Werkstück und der Vorrichtung kein ausreichender Unterdruck erzeugt werden kann, da ein erheblicher Teil des zugeführten Gases durch die Öffnung des Werkstücks entweichen würde.

Es ist Aufgabe der vorliegenden Erfindung, eine Vorrichtung und ein Verfahren zum Halten eines Werkstücks unter Ausnutzung des Venturieffekts und zum Transportieren eines Werkstücks in Richtung der Haltekraft und/oder senkrecht dazu bereitzustellen, dabei jedoch eine Deformation des Werkstücks durch ungleichmäßiges Abkühlen zu Vermeiden.

Diese Aufgabe wird durch die Merkmale der Ansprüche gelöst.

Eine erfindungsgemäße Vorrichtung erlaubt auch Beschleunigungen senkrecht zur Hubkraft, d.h. parallel zur Oberfläche eines zuhaltenden Werkstücks.

Eine erfindungsgemäße Vorrichtung und ein erfindungsgemäßes Verfahren ermöglicht das Anheben von Werkstücken, ohne dass eine Vorrichtung selbst vertikal, d.h., in Richtung des Werkstücks, bewegt werden muß.

Die Erfindung ermöglicht das Anheben, Halten, Transportieren und Ablegen von Werkstücken, die eine ebene Oberfläche mit einer Vertiefung oder einer durchgehenden Öffnung aufweisen.

Die Vorrichtung ist dabei so ausgebildet, daß sie unter Ausnutzung des Venturieffekts durch einen geeigneten Luftstrom in einem Spalt zwischen der Vorrichtung und der ebenen Oberfläche des Werkstücks einen Unterdruck erzeugt. Da der Unterdruck geringer als ein äußerer Umgebungsdruck ist, stellt sich ein Kräftegleichgewicht zwischen dem Gewicht des Werkstücks einerseits und der aus der Druckdifferenz resultierenden Kraft andererseits ein. Dadurch wird eine sogenannte Hubkraft senkrecht auf das Werkstück erzeugt, mittels der das Werkstück angehoben und gehalten werden kann. Des weiteren kann die Vorrichtung einen Haltezapfen aufweisen, der beim Anheben des Werkstücks in die Vertiefung oder die durchgehende Öffnung des Werkstücks eingreift.

Die erfindungsgemäße Vorrichtung hat den Vorteil, daß sehr dünne und empfindliche Werkstücke transportiert werden können. Die Oberfläche des Werkstücks wird lediglich durch die Druckdifferenz von Ober- zur Unterseite des Werkstücks gehalten. Dadurch wird das Werkstück und insbesondere dessen Oberfläche durch den Transport nicht beeinflusst.

Das eingeleitete Gas kühlt das Werkstück während des Transportvorgangs ab, falls es nach der Herstellung bzw. nach einer vorangegangenen Bearbeitung eine erhöhte Temperatur aufweist. Um auch eine Kühlung der der Vorrichtung abgewandten Seite des Werkstücks zu erreichen und damit durch gleichmäßiges Abkühlen des Werkstücks auf beiden Seiten eine Deformation zu vermeiden, ist eine Vorrichtung zum Leiten eines Luftstromes in Richtung dieser Unterseite des Werkstücks vorgesehen.

Der Haltezapfen der erfindungsgemäßen Vorrichtung ermöglicht es, daß das Werkstück selbst bei Beschleunigungen senkrecht zu der durch den Unterdruck bewirkten Hub- bzw. Haltekraft, zuverlässig transportiert werden kann. Der Haltezapfen bewirkt dabei, daß das Werkstück auch bei hohen Beschleunigungen aufgrund seiner Trägheit von der Vorrichtung nicht abgleitet und der zwischen der Vorrichtung und dem Werkstück erzeugte Unterdruck wirksam aufrecht erhalten und somit das Werkstück sicher gehalten werden kann.

Hierbei ist vorzugsweise ein ausreichendes Spiel zwischen Haltezapfen und Vertiefung bzw. durchgehender Öffnung des Werkstücks vorgesehen. Das Spiel ist dabei so gewählt, daß das Werkstück leicht, d.h. ohne zusätzlichen Kraftaufwand von dem Haltezapfen aufgenommen bzw. wieder von diesem entfernt werden kann.

Vorzugsweise ist das Werkstück ein optischer Datenträger, wie eine CD, DVD oder eine Blu-ray-Disk, wobei der Haltezapfen, der vorzugsweise mittig an der Vorrichtung angeordnet ist, an die Abmessungen der Vertiefung bzw. der Öffnung des Werkstücks entsprechend angepaßt ist.

Weiterhin stellt die Erfindung ein Verfahren zum Anheben eines Werkstücks unter Verwendung der erfindungsgemäßen Vorrichtung bereit.

Erfindungsgemäß können unter Ausnutzung des Venturieffects die Werkstücke gegen die Schwerkraft über eine erhebliche Strecke angehoben bzw. in einer Richtung senkrecht zur Werkstückoberfläche transportiert werden. In Tests konnten z.B. 50 mm vertikaler Hub erreicht werden.

Das erfindungsgemäße Verfahren hat daher den Vorteil, daß die Vorrichtung, die mit einem Haltezapfen versehen werden kann, falls das Werkstück eine Oberflächenvertiefung oder eine Öffnung aufweist, lediglich in einem vorbestimmten Abstand horizontal bzw. parallel zur Werkstückoberfläche über dem Werkstück verfahren werden muss, um in eine geeignete Position senkrecht über dem Werkstück positioniert zu werden.

Es ist daher zum Aufnehmen des Werkstücks im Gegensatz zum Stand der Technik keine Bewegung der Vorrichtung mehr senkrecht zur Oberfläche des Werkstücks notwendig. Erfindungsgemäß wird die Vorrichtung z.B. nur horizontal über das Werkstück gefahren, und die Annäherung zwischen Vorrichtung und Werkstück und die Haltewirkung erfolgt ausschließliche durch die durch den Unterdruck erzeugte Hubkraft.

Dies bewirkt eine erhebliche Kostenersparnis: Einerseits kann die Vorrichtung einfacher konstruiert werden, da keine zusätzlichen Einrichtungen für eine Bewegung senkrecht zur Werkstückoberfläche vorgesehen werden müssen; ferner kann die Zykluszeit zum Anheben, Halten und Transportieren und Ablegen gegenüber dem Stand der Technik deutlich reduziert werden, da kein zusätzlicher vertikaler Hub erforderlich ist.

Die Erfindung wird anhand der Zeichnungen näher erläutert. Es zeigen:

Fig. 1        eine Schnittansicht einer erfindungsgemäßen Vorrichtung zum Halten und Transportieren eines Werkstücks,

Fig. 2        eine Teilschnittansicht der erfindungsgemäßen Vorrichtung von Figur 1,

Fig.3        eine Schnittansicht einer erfmdungsgemäßen Vorrichtung zum Anheben, Halten und Transportieren eines Werkstücks,

Fig. 4        eine Schnittansicht einer alternativen Ausführungsform einer erfindungsgemäßen Vorrichtung,

Fig. 5        eine Schnittansicht einer erfindungsgemäßen Vorrichtung zum Anheben und Ablegen eines Werkstücks, und

Fig. 6a und 6b   eine Schnittansicht einer erfindungsgemäßen Vorrichtung mit einer Ausstoßvorrichtung.

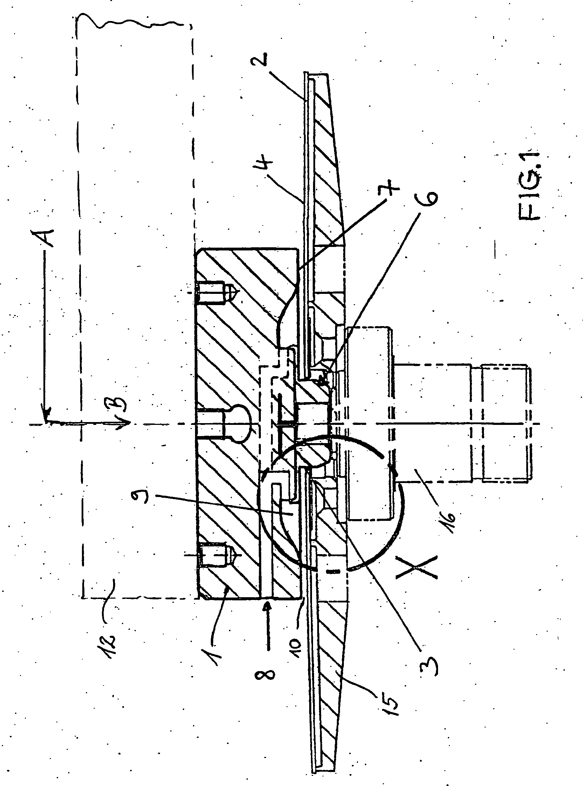

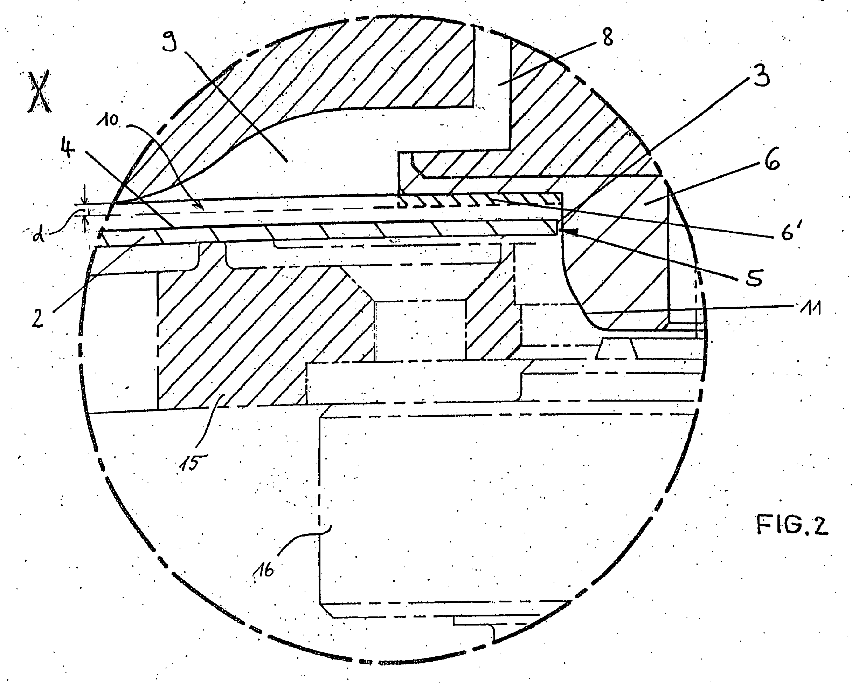

Die Figuren 1 und 2 zeigen schematisch eine Querschnittsansicht bzw. einen Teilquerschnitt einer erfindungsgemäßen Vorrichtung 1 zum Halten und Transportieren eines Werkstücks 2. In dem dargestellten Zustand befindet sich das Werkstück 2 auf einer Auflage 15, die über eine gestrichelt angedeutete Kupplung 16 mit einem nicht dargestellten Maschinenteil verbunden ist. Von dieser Auflage 15 soll das Werkstück 2 mit Hilfe der Vorrichtung 1 abgehoben und abtransportiert werden. Zu diesem Zweck wurde die Vorrichtung 1 mit Hilfe des gestrichelt eingezeichneten Transportarms 12, an dem die Vorrichtung 1 befestigt ist, durch die Bewegung in Richtung des Pfeils A zunächst mit dem Werkstück koaxial ausgerichtet und dann in die dargestellte Position durch Bewegung in Richtung des Pfeils B so weit abgesenkt, daß ein Spalt 10 zwischen der dem Werkstück 2 zugewandten Haltefläche 7 der Vorrichtung 1 verbleibt. In dieser Position greift ein Zentrier- oder Haltezapfen 6 in eine Öffnung 3 des Werkstücks 1 ein. Nun wird Gas oder ein Gasgemisch über eine Gaszuführung 8 in die Vorrichtung 1 eingeleitet. Der Druck, mit dem das Gas bzw. das Gasgemisch eingeleitet wird, beträgt z.B. etwa 1 bis 7 bar, je nach der zum sicheren Halten bzw. Anheben des Werkstücks 2 benötigten Kraft.

Das Gas oder Gasgemisch sollte möglichst keinerlei feste oder flüssige Bestandteile enthalten, um eine Verschmutzung sowohl der Vorrichtung als auch des gehaltenen Werkstücks 2 zu vermeiden. Durch die Gaszuführung 8 wird das Gas in einen Raum 9 zwischen dem Zentrierzapfen 6, einer ebenen Oberfläche 4 des Werkstücks 2 und der planparallelen Haltefläche 7 der Vorrichtung 1 geleitet, so daß sich ein radialer Gasstrom durch den Spalt 10 ausbildet.

Der Raum 9 ist vorzugsweise als Ringraum ausgebildet und der Spalt 10 als Ringspalt, so daß das Gas aus dem Ringraum 9 radial von innen nach außen durch den Ringspalt 10 strömt.

Der dabei ausgenutzte Effekt des hydrodynamischen Paradoxon bewirkt, daß der statische Druck im Bereich des Spaltes 10 und des Raumes 9 geringer ist als der Umgebungsdruck.

Die Geschwindigkeit v des Gases (mit der Dichte p) nimmt radial von innen nach außen entlang des Spaltes 10 ab, während der statische Druck im Bereich des Spaltes 10 von innen nach außen ansteigt.

Dieser Zusammenhang wird durch die Bernoullische Gleichung ausgedrückt.

$$p \quad + \quad \frac{\rho}{2} \cdot v^2 \quad = \quad P \quad = \quad \text{constant}$$

$$\text{statischer Druck} \qquad \text{Staudruck} \qquad \text{Gesamtdruck}$$

Der Haltezapfen 6 dient zum Zentrieren des Werkstücks 2, wenn dieses durch die Vorrichtung 1 aufgrund des Venturieffekts gehalten und transportiert wird. Die Länge des Haltezapfens 6 ist dabei vorzugsweise so gewählt, daß er durch die Öffnung 3 des Werkstück 2 ausreichend nach unten hinaussteht bzw. in eine Vertiefung des Werkstücks 2 ausreichend hineinragt, wenn das Werkstück 2 angehoben ist, um das Werkstück 2 zuverlässig zu halten. Dadurch bleibt das Werkstück 2 auch bei Stößen oder sonstigen äußeren Einwirkungen während des Transports gegen Herausrutschen oder Verkippen an der Vorrichtung 1 gesichert. Ein weiterer Vorteil besteht darin, daß Schwankungen im Abstand zwischen Werkstück und Vorrichtung während des Haltens und des Transports, z.B. aufgrund von Schwankungen in der Gaszufuhr kompensiert werden können und damit die Zuverlässigkeit der Vorrichtung erhöht wird. Abhängig von der Länge des Haltezapfens 6 und der Art des zu transportierenden Werkstücks kann der Abstand zwischen Werkstück und Vorrichtung variiert werden. Dies kann auch durch einen in Fig. 2 gestrichelt eingezeichneten Anschlag 6' am Haltezapfen 6 bewirkt werden. Dieser Anschlag 6' stellt einen vorgegebenen Abstand d zwischen der Haltefläche 7 der Vorrichtung 1 und der Oberfläche 4 des Werkstücks 2 sicher. Somit kann die Größe des Spaltes 10 vorgegeben werden.

Zwischen dem Haltezapfen 6 und der Vertiefung bzw. der durchgehenden Öffnung des Werkstücks 2 besteht ein radiales Spiel, das vorzugsweise so gewählt ist, daß das Werkstück leicht von dem Haltezapfen aufgenommen und abgegeben werden kann. Das Spiel ist vorzugsweise so groß bemessen, daß beim Aufnehmen bzw. Abnehmen des Werkstücks 2 keine Gleitreibung zwischen Haltezapfen 6 und Werkstück 2 auftritt. Das Spiel ist vorzugsweise so gering, daß bei Aufnahme des Werkstücks 2 noch ein ausreichender Unterdruck zwischen Werkstück 2 und Vorrichtung 1 gewährleistet wird, d.h. es sollte allenfalls eine geringe Gasmenge durch den Spalt zwischen Haltezapfen 6 und Öffnung 3 des Werkstücks 2 entweichen. Falls der in Fig. 2 gestrichelt dargestellte Anschlag 6' als flächiges Element vorgesehen ist, an dessen Unterseite die Oberfläche 4 des Werkstücks 2 bei Aufnahme vollständig anliegt, kann im wesentlichen keine Luft zwischen dem Haltezapfen 6 und dem Werkstück 2 entweichen. Alternativ dazu kann jedoch der Anschlag 6' auch beispielsweise rippenförmig ausgebildet sein, so daß Luft zwischen dem Anschlag 6' und der Oberfläche 4 des Werkstücks 2 strömen kann. Auch in diesem Falle sollte jedoch sichergestellt sein, daß allenfalls eine geringe Gasmenge durch den Spalt zwischen Haltezapfen 6 und Öffnung 3 des Werkstücks 2 entweichen kann.

Der Haltezapfen 6 kann in einer Ausführungsform wenigstens eine Aussparung aufweisen, so daß er zum Übernehmen des Werkstücks 2 in eine Zentrierung mit einer korrespondierenden Hervorhebung eintauchen kann.

Der Haltezapfen 6 kann weiterhin über eine Federanordnung vorgespannt und so ausgebildet sein, daß er, zum Aufnehmen des Werkstücks 2, das z.B. von einem anderen Haltezapfen in Position gehalten wird, hinter eine Anlagefläche 11 eingeschoben werden kann. Der Haltezapfen 6 kann aber auch so ausgebildet sein, daß er einen gegenüberliegenden, nicht dargestellten Haltezapfen betätigt, der z.B. über eine Federanordnung vorgespannt ist. Des weiteren kann der Haltezapfen 6 auch auswechselbar an der Vorrichtung 1 angebracht sein, so daß er für ein anderes zu transportierendes Werkstück leicht gegen einen anderen Haltezapfen unterschiedlicher Abmessung ausgetauscht werden kann.

Im Rahmen der Erfindung kann die Vorrichtung auch ohne zentralen Haltezapfen ausgebildet werden und statt dessen an ihrem äußeren Umfang der Haltefläche 7 Haltezapfen in Form von Distanzstücken aufweisen, die geeignet sind, ein seitliches Weggleiten des Werkstücks zu verhindern, und auch zum Begrenzen des Spalts 10 verwendet werden können. Dadurch ist es möglich, Werkstücke auch ohne mittige Öffnung 3 oder Vertiefung anzuheben, zu halten und zu transportieren.

Allgemein stellt die vorliegende Erfindung auch ein Verfahren zum Anheben eines Werkstücks 2 zur Verfügung, unter Verwendung der erfindungsgemäßen Vorrichtung.

Es hat sich gezeigt, daß die erfindungsgemäße Vorrichtung in der Lage ist, durch Erzeugen eines ausreichend großen Gasstroms und unter Ausnutzung des Venturieffekts zwischen Vorrichtung und Werkstück das Werkstück 2 über eine Transportstrecke senkrecht zur Oberfläche des Werkstücks anzuheben bzw. zu bewegen, so daß eine mechanische Bewegung der Transportvorrichtung 1 senkrecht zur Oberfläche des Werkstücks 2 nicht mehr notwendig ist, sondern eine Bewegung in einer Ebene parallel zur Werkstückoberfläche zum vollständigen Transport zwischen der Aufnahmeposition und der Abgabeposition ausreicht.

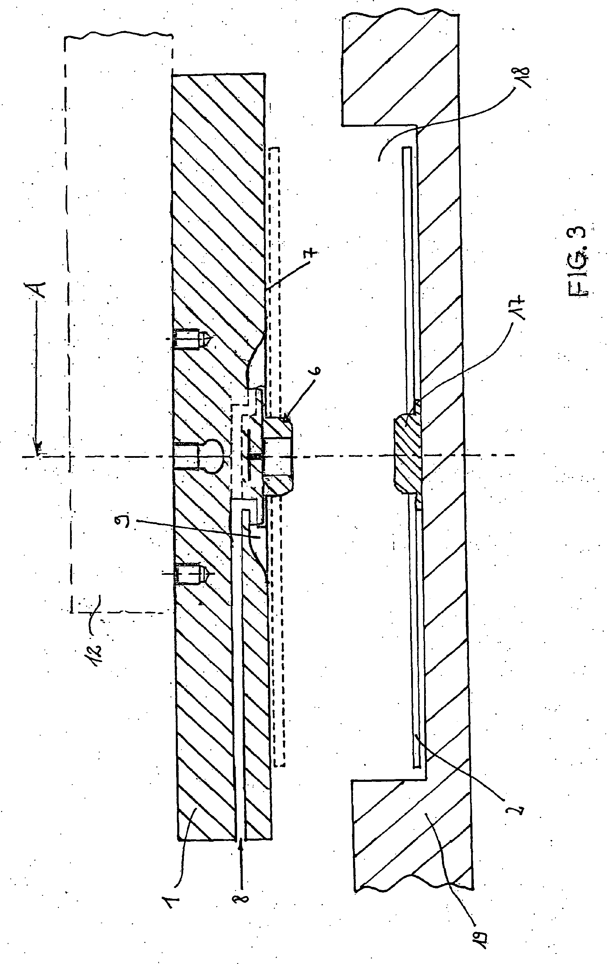

In der in Fig. 3 dargestellten Ausgangsposition befindet sich das Werkstück 2 mit seiner Öffnung 3 durch einen zweiten Haltezapfen 17 zentriert in einer Mulde 18 einer Ablagefläche 19. Die Vorrichtung 1 wurde mit Hilfe des Transportarms 12 in Richtung des Pfeils A parallel zur Oberfläche des Werkstücks 2 mit ihrem Haltezapfen 6 koaxial zum Haltezapfen 17 und damit der Öffnung 3 des Werkstücks 2 ausgerichtet. Im Gegensatz zur Ausführungsform der Fig. 1 ist eine Hubbewegung der Vorrichtung in Axialrichtung nicht erforderlich; vielmehr wird bei der Ausführungsform gemäß Fig. 3 das Werkstück 2 durch Einleiten von Gas und die Vorrichtung 1 unter Ausnutzung des Venturieffekts von dem Haltezapfen 17 abgehoben und dabei auf den Haltezapfen 6 aufgesteckt; in Fig. 3 ist das so abgehobene Werkstück 2 gestrichelt eingezeichnet. Anschließend kann durch eine einfache Horizontalbewegung in Richtung des Pfeils A der Horizontaltransport des Werkstücks 2 erfolgen, ohne daß die Vorrichtung 1 eine dazu und zur Werkstückoberfläche senkrechte Bewegung ausführen muß. Entsprechendes gilt in umgekehrter Richtung für das Absetzen des Werkstücks 2 von der Vorrichtung 1 auf den Haltezapfen 17 in der Mulde 18 der Ablagefläche 19.

Bei diesem Transportvorgang wird gemäß Fig. 3 die Vorrichtung 1 mit dem Haltezapfen 6 koaxial über der Vertiefung oder der Öffnung 3 des Werkstücks 2 positioniert. Der Haltezapfen 6 weist vorzugsweise einen abgeschrägten Rand 11 (vgl. Fig. 2) auf, um eine Führung des anzuhebenden Werkstücks zu gewährleisten und mögliche Ungenauigkeiten in der horizontalen Positionierung der Vorrichtung 1 auszugleichen.

Durch Einleiten von Gas in die Gaszuführung 8 und Erzeugen eines Gasstroms durch den Raum 9 und den Spalt 10 von innen nach außen in radialer Richtung wird das Werkstück 2 automatisch angehoben. Ebenso wie das Spiel 5 zwischen der Öffnung 3 und dem Haltezapfen 6 ermöglicht ein vorgegebenes Spiel zwischen der Öffnung 3 des Werkstücks 2 und dem Haltezapfen 17, daß das Werkstück ohne zusätzlichen Kraftaufwand, z.B. zur Überwindung von Reibungskräften zwischen Werkstück und Haltezapfen, aufgenommen und später wieder abgelegt werden kann.

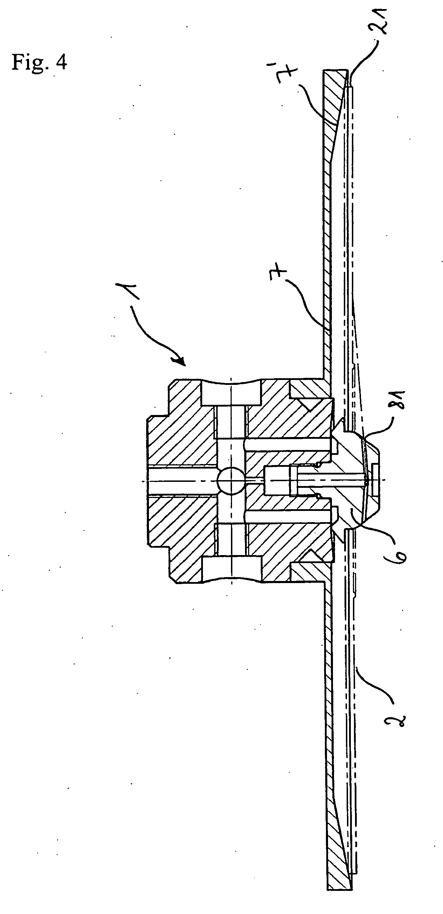

Figur 4 zeigt schematisch eine Querschnittsansicht einer alternativen Ausführungsform der Vorrichtung gemäß der vorliegenden Erfindung. Die Haltefläche 7 der Vorrichtung 1 ist in der in Figur 4 gezeigten Ausführungsform als großer Teller ausgeführt, dessen Fläche größer ist als die Fläche des Werkstücks 2. Der große Teller 7 bewirkt zum einen, dass der Luftverbrauch beim Anheben und Halten des Werkstücks 2 gesenkt wird. Weiterhin kann durch den großen Teller verhindert werden, dass sich beim Anheben des Werkstücks Kratzer auf der der Vorrichtung 1 zugewandten Seite des Werkstücks 2 bilden. Selbst wenn das Werkstück 2 beim Anheben nicht parallel zum Teller 7 bleibt, sondern beispielsweise schräg nach oben springt, berührt das Werkstück 2 nur mit dem Außenrand 21 die konische, schräge Fläche 7' des Tellers 7, und nicht wie im Fall der in Figuren 1 und 2 gezeigten Ausführungsform mit der der Haltefläche 7 der Vorrichtung gemäß Fig. 1 zugewandten Fläche des Werkstücks 2. Gegenüber der in Figur 3 gezeigten Ausführungsform, die auch einen großen Teller 7 aufweist, dessen Fläche über die Fläche des Werkstücks 2 hinaus ragt, berührt bei der in Figur 4 gezeigten Ausführungsform der Rand 21 des Werkstücks 2 den konisch, abgeschrägten Rand 7' des Tellers 7 und wird nicht im Bereich der zentralen - Öffnung durch einen Anschlag 6' (vgl. Fig. 2) gehalten.

In Figur 4 ist außerdem ein weiteres bevorzugtes Merkmal der Erfindung gezeigt. Beim Anheben, Halten bzw. Transportieren von heißen Werkstücken, beispielsweise heißen Disks direkt nach dem Spritzgießen, mittels der Vorrichtung gemäß der vorliegenden Erfindung besteht die Gefahr, dass die Werkstücke durch das einseitige Anblasen mit im allgemeinen kühler Luft bleibend deformiert werden. Um dies zu verhindern, kann im Bereich des Haltezapfens 6 unterhalb der Halteposition für das Werkstück 2 ein zum Werkstück 2 und zur Vorrichtung 1 koaxialer ein Ringkanal 81 vorgesehen sein, durch den in der Fig. 4 schräg noch oben gerichtete Luft auch zu der der Vorrichtung 1 abgewandten Fläche des Werkstücks 2 geleitet werden kann. Somit wird eine gleichmäßige Kühlung des Werkstücks gewährleistet. Durch diesen zusätzlichen Luftstrom wird die Fähigkeit, ein Werkstück anzusaugen nicht beeinträchtigt, sondern sogar unterstützt; der Luftverbrauch wird lediglich geringfügig erhöht.

Im Rahmen der Erfindung kann auch auf einen oder beide Haltezapfen 6 und/oder 17 verzichtet werden, insbesondere wenn das Werkstück 2 keine Öffnung 3 bzw. Vertiefung aufweist. Die Vorrichtung weist hierbei vorzugsweise Haltezapfen auf, die am äußeren Umfang des Werkstücks anliegen, um ein Abgleiten des Werkstücks parallel zur Werkstückoberfläche zu verhindern.

Sowohl im Falle der Ausführungsform der Fig. 1 und 2 als auch der Fig. 3 und 4 muß zum Ablegen des Werkstücks 2 lediglich die Gaszufuhr beendet oder ausreichend verringert werden, so daß der Unterdruck ausreichend reduziert wird und das Werkstück 2 entweder aufgrund der Schwerkraft nach unten auf die Ablage fallen kann oder freigegeben wird.

Wird das Werkstück durch Unterbrechen bzw. Verringern der Gaszufuhr abgelegt, so führt dies in dem beispielsweise in Figur 1 gezeigten Fall, bei dem das Werkstück nach dem Fallenlassen am Außendurchmesser des Werkstücks aufliegt bzw. gehalten wird, zu keinerlei Problemen.

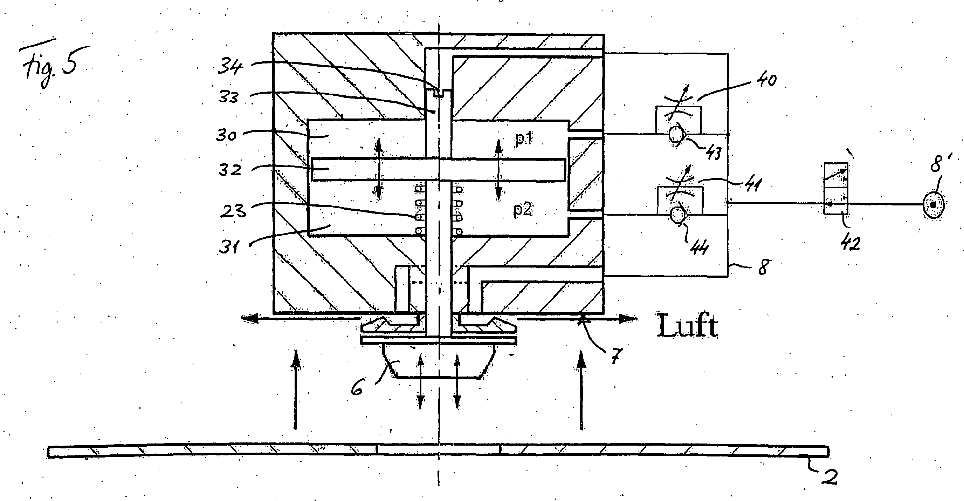

Bei anderen, nicht dargestellten Ausführungsformen wird das Werkstück auf Haltezapfen, wie beispielsweise den in Figur 3 gezeigten Haltezapfen 17 fallen gelassen, deren Durchmesser kaum größer ist als der Innenlochdurchmesser des Werkstücks. In diesem Fall kann es passieren, dass das Werkstück taumelt und es längere Zeit dauert bis das Werkstück ruhig aufliegt. Dieses Problem kann durch die in Figur 5 gezeigte Ausführungsform vermieden werden.

Figur 5 zeigt schematisch eine Querschnittsansicht einer erfindungsgemäßen Vorrichtung, die insbesondere beim Ablegen eines Werkstücks auf einen Haltezapfen vorteilhaft ist. In der in Figur 5 gezeigten Vorrichtung ist der Haltezapfen 6 mit einem axial beweglichen Kolben 32 verbunden, der eine Druckkammer in einem oberen Abschnitt 30 und in einem unteren Abschnitt 31 teilt. Mittels einer Vorrichtung 8' wird Druckluft an die Vorrichtung angelegt, die einerseits, wie oben beschrieben, zum Ansaugen des Werkstücks 2 genutzt wird, in der vorliegenden Ausführungsform aber auch über Rückschlagventile 43, 44, die sich bei Druckluftzufuhr zur Druckkammer öffnen, den oberen und unteren Abschnitt der Druckkammer mit Druckluft versorgt. Wird die Druckluft eingeschaltet, stellt sich ein Druckgleichgewicht zwischen dem oberen und unteren Abschnitt der Druckkammer ein, die Drücke $p_1$ und $p_2$ sind also gleich. Somit bewegt sich der Kolben 32 nicht. Solange das System also mit Druckluft versorgt wird und die Saugeinheit aktiviert ist, werden beide Kammern mit dem gleichen Druck versorgt und die Feder 23 hält den Kolben 32 in seiner oberen Endlage. Wird nun die Zufuhr von Druckluft abgeschaltet, schließen sich die beiden Rückschlagventile 43, 44. Der Kolben 32 und somit auch der Haltezapfen 6 sollen sich nun entgegen der Federkraft der Feder 23 nach unten bewegen. Hierfür ist die obere Drossel 40 stärker eingestellt als die untere Drossel 41, so dass die Luft aus dem unteren Bereich 31 über die Drossel 41 und den Kanal 8 schneller entweichen kann als aus dem oberen Bereich 30 über die Drossel 40 und den Kanal 8. Gleichzeitig verringert sich der Saugeffekt auf das Werkstück 2, und es entsteht ein Druckunterschied zwischen den beiden Abschnitten der Druckkammer; dadurch wird der Kolben 32 nach unten gedrückt, so dass das Werkstück 2 nach unten näher an die Ablagefläche 15 herangeführt und dann nach Beendigung der Saugwirkung dort abgelegt werden kann.

Die Vorrichtung soll danach möglichst schnell wieder in ihrer oberen Ausgangsposition einsatzfähig sein; dazu ist es erforderlich, dass der Kolben 32 mit der Kolbenstange 33 und dem Haltezapfen 6 nach dem Ablegen des Werkstücks 2 sofort wieder nach oben fährt. Wegen des Rückschlagventils 43 und der Drossel 40 kann aus dem oberen Bereich 30 der Druckkammer die Luft nur vergleichsweise langsam ausströmen, so dass die dadurch bewirkte Aufwärtsbewegung des Kolbens 32 relativ langsam ist. Erfindungsgemäß kann eine rasche Aufwärtsbewegung des Kolbens 32 durch eine Schnellentlüftung der oberen Druckkammer 30 erfolgen, durch die der überflüssige Druck schnell abgebaut wird. Der Schlitz 34 am oberen Ende der Kolbenstange 33 oberhalb des Kolbens 32 dient der Entlüftung. Wenn der Kolben 32 die unterste Stellung erreicht hat, gibt der Entlüftungsschlitz 34 eine Öffnung in den Kanal 8 frei, durch die der überflüssige Druck aus der oberen Kammer 30 entweichen kann. Die Druckfeder 23 sorgt dann für das Rückstellen des Kolbens 32 in die obere Ausgangsstellung. Zusätzlich kann durch die beiden Drosseln 40 bzw. 41 die Geschwindigkeit, mit der sich der Kolben 32 bewegt, eingestellt werden.

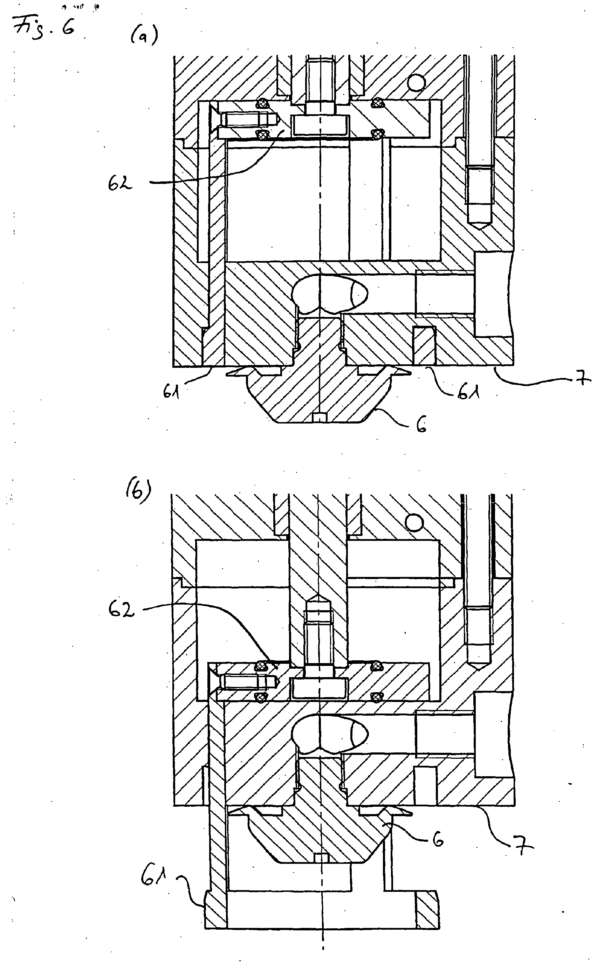

Es kann auch, wie in Figuren 6a und 6b gezeigt, eine den Haltezapfen 6 umgebende Ausstoßvorrichtung 61 in Form eines den Haltezapfens 6 umgebenden Ausstoßrings oder einzelner Ausstoßstempel vorgesehen sein, die im eingefahrenen Zustand bündig mit der Haltefläche 7 abschließt (siehe Fig. 6a). Bei Bedarf, wenn ein angesaugtes bzw. gehaltenes Werkstück abgelegt werden soll, wird die Ausstoßvorrichtung 61 ausgefahren (siehe Fig. 6b) und drückt so das Werkstück von der Haltefläche 7 weg bis der Abstand zwischen Haltefläche 7 und Werkstück so groß wird, dass auch bei aufrecht gehaltenem Luftstrom keine Ansaugwirkung mehr erzielt werden kann.

Vorzugsweise wird die Bewegung der Ausstoßvorrichtung 61 mit einer Vorrichtung ähnlich der mit Bezug auf Fig. 5 beschriebenen Vorrichtung gesteuert. Anstatt also - wie in Fig. 5 gezeigt - den Haltezapfen 6 mit der Kolbenstange 33 und dem Kolben 32 zu verbinden, wird die Ausstoßvorrichtung 61 mit einem Kolben 62 verbunden, so dass die Bewegung der Ausstoßvorrichtung 61 wie oben mit Bezug auf Fig. 5 beschrieben gesteuert werden kann. Insbesondere beim Ablegen auf eine Zentrierspitze bzw. einen Haltezapfen 17 besteht nämlich die Gefahr, dass der in Fig. 5 gezeigte bewegliche Haltezapfen 6 auf den gegenüberliegenden (nicht dargestellten) Haltezapfen stößt, ohne das Taumeln des Werkstücks verhindern zu können. Dies kann durch die Ausstoßvorrichtung 61 vermieden werden.

**Patentansprüche**

1. Vorrichtung (1) zum Anheben, Halten und/oder Transportieren eines Werkstücks (2), das eine ebene Oberfläche (4) auf der Halteseite und eine Vertiefung oder durchgehende Öffnung (3) in dieser Oberfläche (4) aufweist, mit :

   (a) einem mit einer Vertiefung oder der Öffnung (3) in der Oberfläche (4) des Werkstücks (2) in Eingriff bringbaren Haltezapfen (6),
   (b) einer den Haltezapfen (6) umgebenden, der ebenen Oberfläche der Halteseite des Werkstücks (2) zugewandten und zu dieser planparallelen Haltefläche (7),
   (c) einer Gaszuführung (8) zum Einleiten von Gas oder einem Gasgemisch im Bereich des Haltezapfens (6), in einen Raum (9) zwischen dem Haltezapfen (6), der ebenen Oberfläche (4) des Werkstücks (2) und dem planparallelen Flächenabschnitt (7) und Ausbilden eines Gasstroms durch den zwischen der Oberfläche (4) des Werkstücks (2) und dem planparallelen Flächenabschnitt (7) gebildeten Spalts (10), und
   (d) einer Einrichtung (81) zum Leiten des Gases oder Gasgemisches in Richtung der der Vorrichtung (1) abgewandten Fläche des Werkstücks (2), vorzugsweise in spitzem Winkel.

2. Vorrichtung nach Anspruch 1, wobei der Haltezapfen (6) und die planparallele Haltefläche (7) axialsymmetrisch ausgebildet und zueinander koaxial angeordnet sind.

3. Vorrichtung nach Anspruch 1 oder 2, wobei der Durchmesser des Haltezapfens (6) an das Mittelloch einer CD, DVD oder einer Blu-ray-Disk angepasst ist.

4. Vorrichtung nach einem der Ansprüche 1 bis 3, wobei der Haltezapfen (6) eine vorbestimmte Länge aufweist, so daß der Haltezapfen (6) über die Öffnung (3) eines Werkstücks (2) hinaussteht bzw. in die Vertiefung eines Werkstücks (2) hineinragt, und das Werkstück (2) sich während des Haltens oder des Transports durch die Vorrichtung (1) nicht ungewollt von dem Haltezapfen (6) lösen kann.

5. Vorrichtung nach einem der Ansprüche 1 bis 4, wobei der Haltezapfen (6) lösbar an der Vorrichtung (1) befestigbar ist.

6. Vorrichtung nach einem der Ansprüche 1 bis 5, wobei der Haltezapfen (6) vorzugsweise einen abgeschrägten Rand (11) aufweist.

7. Vorrichtung nach einem der Ansprüche 1 bis 6, wobei der Haltezapfen (6) zum Zentrieren in einem entsprechend angepaßten komplementären Gegenstück beim Aufnehmen oder Ablegen des Werkstücks (2) wenigstens eine Aussparung oder einen Vorsprung aufweist.

8. Vorrichtung nach einem der Ansprüche 1 bis 7, wobei der Haltezapfen (6) oder eine Ausstoßvorrichtung (61) so ausgebildet ist, daß er/sie bezüglich der Vorrichtung (1) senkrecht zur Haltefläche (7) verschiebbar ist.

9. Vorrichtung nach Anspruch 8, wobei der Haltezapfen (6) bzw. die Ausstoßvorrichtung (61) über eine Federanordnung zur Vorrichtung (1) hin vorspannbar ist.

10. Vorrichtung nach einem der Ansprüche 8 oder 9, wobei der Haltezapfen (6) bzw. die Ausstoßvorrichtung (61) an einem koaxialen Kolben (32) angeordnet ist, der bei Abschalten bzw. Verringern der Zufuhr des Gases oder des. Gasgemisches mit dem Haltezapfen (6) axial bewegbar ist, so dass der Haltezapfen (6) bzw. die Ausstoßvorrichtung (61) von der Haltefläche (7) weg bewegbar ist.

11. Vorrichtung nach einem der Ansprüche 1 bis 10, wobei ein Spiel (5) zwischen dem Haltezapfen (6) und der Vertiefung oder durchgehenden Öffnung (3) des Werkstücks (2) vorgesehen ist, das vorzugsweise so bemessen ist, daß das Werkstück (2) ohne störende Reibungskräfte von dem Haltezapfen (6) aufgenommen und wieder entfernt werden kann.

12. Vorrichtung nach einem der Ansprüche 1 bis 11, wobei sich der Querschnitt des Raums (9) in radialer Richtung von innen nach außen verringert.

13. Vorrichtung nach Anspruch 12, wobei der Raum (9) eine konische Form aufweist.

14. Vorrichtung nach einem der Ansprüche 1 bis 13, wobei der Raum (9) als Ringraum ausgebildet ist.

15. Vorrichtung nach einem der Ansprüche 1 bis 14, wobei der Spalt (10) zwischen der Haltefläche (7) und dem Werkstück (2) als Ringspalt ausgebildet ist.

16. Vorrichtung nach einem der Ansprüche 1 bis 15, wobei das Gas oder Gasgemisch mit einem vorbestimmten Druck in die Vorrichtung eingeleitet wird, der so gewählt ist, daß in dem Spalt (10) ein Unterdruck erzeugt und **dadurch** auf das Werkstück (2) eine zum Halten des Werkstücks (2) ausreichende Hubkraft ausgeübt wird.

17. Vorrichtung nach Anspruch 16, wobei die Vorrichtung an der planparallelen Haltefläche (7) wenigstens ein Distanzstück aufweist, um den Spalt (10) zu begrenzen.

18. Vorrichtung nach einem der Ansprüche 1 bis 17, wobei der Haltezapfen (6) einen Anschlag (6') aufweist, durch den ein vorgegebener Abstand (d) zwischen der Haltefläche (7) und der Oberfläche (4) des Werkstücks (2) sichergestellt wird.

19. Vorrichtung nach einem der Ansprüche 1 bis 18, wobei das Gas oder Gasgemisch mit einem vorbestimmten Druck in die Vorrichtung eingeleitet wird, der so gewählt ist, daß zwischen der Vorrichtung und der Oberfläche (4) des Werkstücks (2) ein Unterdruck erzeugt und **dadurch** auf das Werkstück (2) eine Hubkraft zum Anheben des Werkstücks (2) über einen vorbestimmten Hubweg ausgeübt wird.

20. Vorrichtung nach einem der Ansprüche 1 bis 19, wobei das Gas oder Gasgemisch über die Gaszuführung (8) mit einem Druck von etwa 1 bis 7 bar eingeleitet wird.

21. Vorrichtung nach einem der Ansprüche 19 oder 20, wobei der Hubweg etwa 50 mm beträgt.

22. Vorrichtung nach einem der Ansprüche 1 bis 21, wobei die Vorrichtung (1) im wesentlichen axialsymmetrisch ist.

23. Vorrichtung nach einem der Ansprüche 1 bis 22, wobei die Haltefläche (7) zumindest in Teilbereichen über den äußeren Umfang des Werkstücks (2) radial hinausragt und auf der dem Umfang des Werkstücks (2) zugewandten Seite zum Werkstück hin abgeschrägt, vorzugsweise konisch ausgebildet ist.

24. Verfahren zum Anheben, Halten und/oder Transportieren eines Werkstücks (2), das eine ebene Oberfläche (4) auf der Halteseite und eine Vertiefung oder durchgehende Öffnung (3) in dieser Oberfläche (4) aufweist, unter Verwendung der Vorrichtung gemäß einem der Ansprüche 1 bis 23, mit folgenden Schritten:

(a) Bewegen der Vorrichtung (1) mit dem Haltezapfen (6) in einem bestimmten Abstand zu dem Werkstück (2) in eine Position koaxial über die Vertiefung oder durchgehende Öffnung (3) des Werkstücks (2),
(b) Einleiten eines Gases oder Gasgemisches in die Gaszuführung (8) der Vorrichtung mit einem vorbestimmten Druck und Ausbilden eines Gasstroms durch den zwischen der Oberfläche (4) des Werkstücks (2) und der planparallelen Haltefläche (7) der Vorrichtung gebildeten Spalt (10) in Richtung der der Vorrichtung (1) abgewandten Flädhe des Werkstücks (2), vorzugsweise in spitzem Winkel, zum Ausüben einer Hubkraft auf das Werkstück (2), und
(c) Erzeugen eines Unterdrucks in dem Spalt (10) zum Ausüben einer Hubkraft auf das Werkstück (2).

25. Verfahren nach Anspruch 24, wobei die Vorrichtung parallel zu der Oberfläche (4) des Werkstücks bewegt und positioniert und der Haltezapfen senkrecht über der Vertiefung oder der Öffnung (3) des Werkstücks (2) positioniert wird.

26. Verfahren nach Anspruch 24 oder 25 mit dem Schritt: Einleiten des Gases oder Gasgemisches mit einem vorbestimmten Druck in die Vorrichtung; der so gewählt ist, daß ein Unterdruck zwischen der Vorrichtung und der Oberfläche (4) des Werkstücks (2) erzeugt wird, der eine Hubkraft zum Anheben des Werkstücks (2) über einen vorbestimmten Hubweg bewirkt.

**27.** Verfahren nach Anspruch 24, 25 oder 26, mit dem Schritt: Einleiten des Gases oder Gasgemisches in die Gaszuführung (8) mit einem Druck von etwa 1 bis 7 bar.

**28.** Verfahren nach einem der Ansprüche 24 bis 27, wobei der Hubweg etwa 50 mm beträgt.

**29.** Verfahren nach einem der Ansprüche 24 bis 28, wobei die Vorrichtung zunächst parallel und senkrecht zu der Oberfläche (4) des Werkstücks bewegt und positioniert wird und wobei der Spalt (10) beim Bewegen der Vorrichtung in senkrechter Richtung hin zu der Oberfläche (4) des Werkstücks vorzugsweise durch mindestens ein Distanzstück an der Vorrichtung begrenzt wird.

**30.** Verfahren nach Anspruch 29, wobei das Gas oder Gasgemisch mit einem vorbestimmten Druck in die Vorrichtung eingeleitet wird, der so gewählt ist, daß ein Unterdruck in dem Spalt (10) erzeugt wird, der eine Hubkraft zum Halten des Werkstücks (2) bewirkt.

**31.** Verfahren nach Anspruch einem der Ansprüche 24 bis 30, mit dem Schritt:

Herunterlassen bzw. Freigeben des Werkstücks (2) durch Beenden der Gaszufuhr.


**Claims**

**1.** Apparatus (1) for lifting, holding and/or transporting a workpiece (2), which comprises a plane surface (4) on the holding surface and an impression or through-going opening (3) on said surface (4), comprising:

(a) a holding plug (6) which can engage with an impression or the opening (3) in the surface (4) of the workpiece (2),
(b) a holding surface (7) surrounding the holding plug (6), facing the plane surface of the holding side of the workpiece (2) and being plane-parallel to said surface,
(c) a gas supply (8) for inserting gas or a gas mixture into a space (9) located in the area of the holding plug (6), between the holding plug (6), the plane surface (4) of the workpiece (2) and the plane-parallel area section (7) and for generating a gas stream through a gap (10) formed between the surface (4) of the workpiece (2) and the plane-parallel area section (7); and
(d) a means (81) for guiding the gas or the gas mixture in the direction of the surface of the workpiece (2) facing away from the apparatus (1), preferably at an acute angle.

**2.** The apparatus according to claim 1, wherein the holding plug (6) and the plane parallel holding surface (7) are configured axially symmetrical and are arranged coaxially with respect to each other.

**3.** The apparatus according to claim 1 or 2, wherein the diameter of the holding plug (6) is adjusted to the central opening of a CD, DVD or a Blu-ray disk.

**4.** The apparatus according to any one of claims 1 to 3, wherein the holding plug (6) comprises a predetermined length, so that the holding plug (6) extends over the opening (3) of a workpiece (2) or into the impression of a workpiece (2), and that the workpiece (2) cannot drop unintentionally from the holding plug (6) when held or transported by the apparatus (1).

**5.** The apparatus according to any one of claims 1 to 4, wherein the holding plug (6) can be fixed detachably at the apparatus (1).

**6.** The apparatus according to any one of claims 1 to 5, wherein the holding plug (6) preferably comprises a beveled edge (11).

**7.** The apparatus according to any one of claims 1 to 6, wherein the holding plug (6) comprises at least one recess or at least one projection for centering in a correspondingly adapted complementary counterpart when the workpiece (2) is lifted or deposited.

**8.** The apparatus according to any one of claims 1 to 7, wherein the holding plug (6) or an ejecting means (61) is configured such that it is displaceable vertically to the holding surface (7) with respect to the apparatus (1).

9. The apparatus according to claim 8, wherein the holding plug (6) or the ejecting means (61) can be biased towards the apparatus (1) by a spring arrangement.

10. The apparatus according to any one of claims 8 or 9, wherein the holding plug (6) or the ejecting means (61) is arranged at a coaxial piston (32) which can be moved axially with the holding plug (6) when the supply of the gas or the gas mixture is interrupted or reduced, so that the holding plug (6) or the ejecting means (61) can be moved away from the holding surface (7).

11. The apparatus according to any one of claims 1 to 10, wherein a play (5) is provided between the holding plug (6) and the impression or the through-going opening (3) of the workpiece (2), the play being preferably adjusted in such a manner, that the workpiece (2) can be picked up and deposited again by the holding plug (6) without any disturbing friction forces.

12. The apparatus according to any one of claims 1 to 11, wherein the cross-section of the space (9) diminishes in radial direction from the inner side towards the outer side.

13. The apparatus according to claim 12, wherein the space (9) comprises a conical shape.

14. The apparatus according to any one of claims 1 to 13, wherein the space (9) is configured as ringspace.

15. The apparatus according to any one of claims 1 to 14, wherein the gap (10) between the holding surface (7) and the workpiece (2) is configured as ringgap.

16. The apparatus according to any one of claims 1 to 15, wherein the gas or the gas mixture is inserted into the apparatus at a predetermined pressure, which is chosen such that a low pressure is generated in the gap (10) and, thus, a sufficient lifting force for holding the workpiece (2) is exerted onto the workpiece (2).

17. The apparatus according to claim 16, wherein the apparatus comprises at least one distance piece at the plane-parallel holding surface (7), the distance piece limiting the gap (10).

18. The apparatus according to any one of claims 1 to 17, wherein the holding plug (6) comprises a stop (6') by which a predetermined distance (d) between the holding surface (7) and the surface (4) of the workpiece (2) is guaranteed.

19. The apparatus according to any one of claims 1 to 18, wherein the gas or gas mixture is inserted into the apparatus at a predetermined pressure, which is chosen such that a low pressure is generated between the apparatus and the surface (4) of the workpiece (2) and, thus, a lifting force for lifting the workpiece (2) over a predetermined lifting distance is exerted onto the workpiece (2).

20. The apparatus according to any one of claims 1 to 19, wherein the gas or gas mixture is inserted over the gas supply (8) at a pressure of about 1 bar to 7 bar.

21. The apparatus according to any one of claims 19 or 20, wherein the lifting distance is about 50 mm.

22. The apparatus according to any one of claims 1 to 21, wherein the apparatus (1) is essentially axially symmetrical.

23. The apparatus according to any one of claims 1 to 22, wherein the holding surface (7) radially extends at least partially over the outer circumference of the workpiece (2) and is configured beveled, preferably conical towards the workpiece at the side facing the circumference of the workpiece (2).

24. Method for lifting, holding and/or transporting a workpiece (2) comprising a plane surface (4) at the holding side and an impression or a through-going opening (3) on said surface (4), the method using the apparatus according to any one of claims 1 to 23, comprising the following steps:

(a) moving the apparatus (1) with the holding plug (6) at a predetermined distance to the workpiece (2) into a position coaxially above the impression or through-going opening (3) of the workpiece (2),
(b) inserting a gas or a gas mixture into the gas supply (8) of the apparatus at a predetermined pressure and generating a gas stream through the gap (10) formed between the surface (4) of the workpiece (2) and the plane-parallel holding surface (7) of the apparatus in the direction of the surface of the workpiece (2) facing away from the apparatus (1), preferably at an acute angle, for exerting a lifting force onto the workpiece (2), and (c) generating a low pressure in the gap (10) for exerting a lifting force onto the workpiece (2).

25. The method according to claim 24, wherein the apparatus is moved and positioned parallel to the surface (4) of the workpiece and the holding plug is positioned vertically above the impression or opening (3) of the workpiece (2).

26. The method according to claim 24 or 25, comprising the step: inserting the gas or the gas mixture into the apparatus at a predetermined pressure which is selected such that a low pressure is generated between the apparatus and the surface (4) of the workpiece (2) which effects a lifting force for lifting the workpiece (2) along a predetermined lifting path.

27. The method according to claim 24, 25 or 26 comprising the step: inserting the gas or the gas mixture into the gas supply (8) at a pressure of about 1 bar to 7 bar.

28. The method according to any one of claims 24 to 27, wherein the lifting distance is about 50 mm.

29. The method according to any one of claims 24 to 28, wherein the apparatus is first moved and positioned in a direction parallel and vertical to the surface (4) of the workpiece and wherein the gap (10) is preferably limited by at least one distance piece arranged at the apparatus when the apparatus is moved vertically in the direction towards the surface (4) of the workpiece .

30. The method according to claim 29, wherein the gas or the gas mixture is inserted into the apparatus at a predetermined pressure which is selected such that a low pressure is generated in the gap (10), the low pressure effecting a force for holding the workpiece (2).

31. The method according to any one of claims 24 to 30, comprising the step: depositing or releasing the workpiece (2) by interrupting the gas supply.


**Revendications**

1. Dispositif (1) pour soulever, maintenir et/ou transporter une pièce (2), qui présente une surface plate (4) sur la face de maintien et une cavité ou une ouverture traversante (3) dans cette surface (4), comprenant :

   (a) un tourillon de maintien (6) pouvant être amené en prise avec une cavité ou l'ouverture (3) dans la surface (4) de la pièce (2),
   (b) une surface de maintien (7) entourant le tourillon de maintien (6), tournée vers la surface plate de la face de maintien de la pièce (2) et plan-parallèle par rapport à celle-ci,
   (c) une alimentation en gaz (8) pour acheminer un gaz ou un mélange gazeux dans la zone du tourillon de maintien (6), dans un espace (9) compris entre le tourillon de maintien (6), la surface plate (4) de la pièce (2) et la section de surface plan-parallèle (7) et former un courant de gaz à travers la fente (10) formée entre la surface (4) de la pièce (2) et la section de surface plan-parallèle (7), et
   (d) un dispositif (81) pour guider le gaz ou le mélange gazeux en direction de la surface de la pièce (2) opposée au dispositif (1), de préférence sous un angle aigu.

2. Dispositif selon la revendication 1, dans lequel le tourillon de maintien (6) et la surface de maintien plan-parallèle (7) se présentent sous une forme à symétrie axiale et sont aménagés coaxialement l'un à l'autre.

3. Dispositif selon la revendication 1 ou 2, dans lequel le diamètre du tourillon de maintien (6) est ajusté au trou central d'un CD, DVD ou d'un disque Blu-ray.

4. Dispositif selon l'une quelconque des revendications 1 à 3, dans lequel le tourillon de maintien (6) présente une longueur prédéterminée de sorte que le tourillon de maintien (6) dépasse de l'ouverture (3) d'une pièce (2) ou s'enfonce dans l'évidement d'une pièce (2) et que la pièce (2) ne puisse se dégager involontairement du tourillon de maintien (6) pendant le maintien ou le transport par le dispositif (1).

5. Dispositif selon l'une quelconque des revendications 1 à 4, dans lequel le tourillon de maintien (6) peut être fixé de manière détachable sur le dispositif (1).

**6.** Dispositif selon l'une quelconque des revendications 1 à 5, dans lequel le tourillon de maintien (6) présente de préférence un bord biseauté (11).

**7.** Dispositif selon l'une quelconque des revendications 1 à 6, dans lequel le tourillon de maintien (6) présente au moins un évidement ou une saillie pour le centrage dans une contre-pièce complémentaire adaptée de manière correspondante lors de la réception ou du retrait de la pièce (2).

**8.** Dispositif selon l'une quelconque des revendications 1 à 7, dans lequel le tourillon de maintien (6) ou un dispositif d'éjection (61) se présente sous une forme telle qu'il puisse être déplacé par rapport au dispositif (1) perpendiculairement à la surface de maintien (7).

**9.** Dispositif selon la revendication 8, dans lequel le tourillon de maintien (6) ou le dispositif d'éjection (61) peut être précontraint par un dispositif à ressort sur le dispositif (1).

**10.** Dispositif selon l'une quelconque des revendications 8 ou 9, dans lequel le tourillon de maintien (6) ou le dispositif d'éjection (61) est aménagé sur un piston coaxial (32), qui peut être déplacé axialement lors d'un arrêt ou d'une diminution de l'acheminement du gaz ou du mélange gazeux avec le tourillon de maintien (6) de sorte que le tourillon de maintien (6) ou le dispositif d'éjection (61) puisse être éloigné de la surface de maintien (7).

**11.** Dispositif selon l'une quelconque des revendications 1 à 10, dans lequel il est prévu entre le tourillon de maintien (6) et la cavité ou l'ouverture traversante (3) de la pièce (2) un jeu (5), qui est dimensionné de préférence de sorte que la pièce (2) puisse être reçue et à nouveau enlevée du tourillon de maintien (6) sans forces de frottement gênantes.

**12.** Dispositif selon l'une quelconque des revendications 1 à 11, dans lequel la section transversale de l'espace (9) se réduit dans la direction radiale de l'intérieur vers l'extérieur.

**13.** Dispositif selon la revendication 12, dans lequel l'espace (9) présente une forme conique.

**14.** Dispositif selon l'une quelconque des revendications 1 à 13, dans lequel l'espace (9) est conformé en espace annulaire.

**15.** Dispositif selon l'une quelconque des revendications 1 à 14, dans lequel la fente (10) est conformée en fente annulaire entre la surface de maintien (7) et la pièce (2).

**16.** Dispositif selon l'une quelconque des revendications 1 à 15, dans lequel le gaz ou le mélange gazeux est acheminé dans le dispositif à une pression prédéterminée, qui est choisie de manière à générer une dépression dans la fente (10) et à exercer de la sorte, sur la pièce (2), une force de levage suffisante pour la maintenir.

**17.** Dispositif selon la revendication 16, dans lequel le dispositif présente sur la surface de maintien plan-parallèle (7) au moins une pièce d'écartement pour délimiter la fente (10).

**18.** Dispositif selon l'une quelconque des revendications 1 à 17, dans lequel le tourillon de maintien (6) présente une butée (6'), qui garantit une distance prédéfinie (d) entre la surface de maintien (7) et la surface (4) de la pièce (2).

**19.** Dispositif selon l'une quelconque des revendications 1 à 18, dans lequel le gaz ou le mélange gazeux est acheminé dans le dispositif à une pression prédéterminée, qui est choisie de manière à générer une dépression entre le dispositif et la surface (4) de la pièce (2) et à exercer de la sorte, sur la pièce (2), une force de levage pour la soulever sur une course de levage prédéterminée.

**20.** Dispositif selon l'une quelconque des revendications 1 à 19, dans lequel le gaz ou le mélange gazeux est acheminé par l'alimentation en gaz (8) à une pression d'environ 1 à 7 bars.

**21.** Dispositif selon l'une quelconque des revendications 19 ou 20, dans lequel la course de levage est d'environ 50 mm.

**22.** Dispositif selon l'une quelconque des revendications 1 à 21, dans lequel le dispositif (1) présente une symétrie sensiblement axiale.

**23.** Dispositif selon l'une quelconque des revendications 1 à 22, dans lequel la surface de maintien (7) dépasse radialement au moins dans des zones partielles sur la périphérie externe de la pièce (2) et se présente sous forme biseautée vers la pièce, de préférence sous forme conique, sur la face tournée vers la périphérie de la pièce (2).

**24.** Procédé pour soulever, maintenir et/ou transporter une pièce (2), qui présente une surface plate (4) sur la face de maintien et une cavité ou une ouverture traversante (3) dans cette surface (4), en utilisant le dispositif selon l'une quelconque des revendications 1 à 23 avec les étapes suivantes consistant à :

(a) déplacer le dispositif (1) avec le tourillon de maintien (6) à une certaine distance de la pièce (2) dans une position coaxialement à la cavité ou l'ouverture traversante (3) de la pièce (2),
(b) acheminer un gaz ou un mélange gazeux dans l'alimentation en gaz (8) du dispositif à une pression prédéterminée et former un courant de gaz à travers la fente (10) formée entre la surface (4) de la pièce (2) et la surface de maintien plan-parallèle (7) du dispositif dans la direction de la surface de la pièce (2) opposée au dispositif (1), de préférence sous un angle aigu, pour exercer une force de levage sur la pièce (2), et
(c) générer une dépression dans la fente (10) pour exercer une force de levage sur la pièce (2).

**25.** Procédé selon la revendication 24, dans lequel le dispositif est déplacé et positionné parallèlement à la surface (4) de la pièce et le tourillon de maintien est positionné perpendiculairement sur la cavité ou l'ouverture (3) de la pièce (2).

**26.** Procédé selon la revendication 24 ou 25 avec l'étape consistant à acheminer le gaz ou le mélange gazeux dans le dispositif à une pression prédéterminée, qui est choisie de manière à générer une dépression entre le dispositif et la surface (4) de la pièce (2), qui provoque une force de levage pour soulever la pièce (2) sur une course de levage prédéterminée.

**27.** Procédé selon la revendication 24, 25 ou 26, avec l'étape consistant à acheminer le gaz ou le mélange gazeux dans l'alimentation en gaz (8) à une pression d'environ 1 à 7 bars.

**28.** Procédé selon l'une quelconque des revendications 24 à 27, dans lequel la course de levage est d'environ 50 mm.

**29.** Procédé selon l'une quelconque des revendications 24 à 28, dans lequel le dispositif est d'abord déplacé et positionné parallèlement et perpendiculairement à la surface (4) de la pièce et dans lequel la fente (10) est délimitée de préférence par au moins une pièce d'écartement sur le dispositif lors du déplacement de ce dernier dans la direction perpendiculaire à la surface (4) de la pièce.

**30.** Procédé selon la revendication 29, dans lequel le gaz ou le mélange gazeux est acheminé dans le dispositif à une pression prédéterminée, qui est choisie de manière à générer une dépression dans la fente (10), qui provoque une force de levage pour maintenir la pièce (2).

**31.** Procédé selon l'une quelconque des revendications 24 à 30, avec l'étape consistant à abaisser ou libérer la pièce (2) en mettant fin à l'acheminement de gaz.

FIG.1

EP 1 641 037 B1

FIG.2

EP 1 641 037 B1

FIG. 3

EP 1 641 037 B1

Fig. 4

Fig. 5

p1

p2

Luft

Fig. 6

(a)

62

61      61      7

6

(b)

62

6      7

61

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3536432 A1
- DE 2539036 A1
- DE 3642937 A1